# EUROPÄISCHE PATENTSCHRIFT

(11) **EP 1 673 534 B1**
(45) Veröffentlichungstag und Bekanntmachung des Hinweises auf die Patenterteilung: **08.05.2013**
(21) Anmeldenummer: 04791195.3
(22) Anmeldetag: 11.10.2004
(51) Int. Cl.: F02M 61/16, F02M 59/46, F02M 51/06, H01L 41/053, H01L 41/083

(54) **AUFNAHMEHÜLSE FÜR EINEN AKTORKÖRPER**
RECEIVING SLEEVE FOR AN ACTUATOR BODY
DOUILLE DE RECEPTION POUR CORPS D'ACTIONNEUR

(30) Priorität: 14.10.2003 DE 10347774
(43) Veröffentlichungstag der Anmeldung: 28.06.2006
(73) Patentinhaber: Continental Automotive GmbH, 30165 Hannover (DE)
(72) Erfinder: DÖLLGAST, Bernd, 91054 Erlangen (DE); SANFTLEBEN, Emanuel, 93102 Geisling (DE); UNRUH, Marcus, 93197 Zeitlarn (DE)
(86) Internationale Anmeldenummer: PCT/EP2004/052500
(87) Internationale Veröffentlichungsnummer: WO 2005/035972

(56) Entgegenhaltungen:
- DE-A- 10 225 408
- DE-A- 19 826 339
- US-A- 6 057 633
- US-B1- 6 274 967

## Beschreibung

Die Erfindung betrifft eine Aufnahmehülse für einen Aktorkörper gemäß dem Oberbegriff des Anspruchs 1, insbesondere zur Aufnahme eines Piezostapels eines Piezoaktors, der zum Antrieb eines Injektors einer Einspritzanlage für eine Brennkraftmaschine vorgesehen ist.

Bei der Herstellung von Piezoaktoren für Injektoren von Einspritzanlagen ist es bekannt, jeweils einen Piezostapel in eine aus Kunststoff bestehende Aufnahmehülse einzusetzen und nach der elektrischen Kontaktierung des Piezostapels in der Aufnahmehülse mit Silikon zu vergießen, wodurch der Piezostapel und auch die elektrischen Anschlussstifte in dem Piezoaktor unverrückbar fixiert werden. Hierzu weist die bekannte Aufnahmehülse Führungsbohrungen auf, deren Innenquerschnitt an den Außenquerschnitt des Piezostapels angepasst ist, so dass die Führungsbohrungen den Piezostapel im eingesetzten Zustand fixieren.

Nachteilig an dieser bekannten Aufnahmehülse zur Herstellung eines Piezoaktors ist die Tatsache, dass die Position des Piezostapels in dem fertig vergossenen Piezoaktor teilweise von den vorgegebenen Spezifikationen abweicht, was beim Einbau des Piezoaktors zu Problemen führen kann.

Der Erfindung liegt deshalb die Aufgabe zugrunde, die vorstehend beschriebene bekannte Aufnahmehülse für einen Piezoaktor dahingehend zu verbessern, dass die Positionierung des Piezostapels in der Aufnahmehülse möglichst exakt den vorgegebenen Spezifikationen entspricht.

Aus der DE 198 26 339 A1 ist ein Piezoaktor für ein Ventil bekannt, bei dem ein Piezostapel durch Federelemente vorgespannt und durch ein federndes Membranelement in einer Anlageposition gehalten wird. Das US-Patent 6,274,967 offenbart ein Gehäuse für Piezostapel mit einem zylindrischen Federelement. Ein anderes Gehäuse mit elastischen Klemmelementen zur Fixierung von Piezoaktoren ist beispielsweise aus dem US-Patent 6,057,633 bekannt.

Die oben genannte Aufgabe wird, ausgehend von der eingangs beschriebenen bekannten Aufnahmehülse gemäß dem Oberbegriff des Anspruchs 1, durch die kennzeichnenden Merkmale des Anspruchs 1 gelöst.

Die Erfindung geht von der technischen Erkenntnis aus, dass die Fehlpositionierung des Piezostapels in dem fertig vergossenen Piezoaktor durch Bauteiltoleranzen des Piezostapels und der zugehörigen Führungsbohrungen in der Aufnahmehülse verursacht wird. So muss der Innenquerschnitt der Führungsbohrungen der Aufnahmehülse so groß ausgelegt werden, dass der Piezostapel auch bei ungünstigen Toleranzabweichüngen noch in die zugehörigen Führungsbohrungen der Aufnahmehülse eingeführt werden kann. Diese Bemaßung der Führungsbohrungen der Aufnahmehülse führt jedoch meist zu einer Spielpassung zwischen dem Piezostapel und der Aufnahmehülse, was mit einer entsprechend ungenauen Positionierung des Piezostapels innerhalb der Aufnahmehülse verbunden ist.

Darüber hinaus beruht die Erfindung auf der technischen Erkenntnis, dass die Positionierungsfehler auch in Fehlzentrierungen des Piezostapels innerhalb der Aufnahmehülse bestehen.

Die Erfindung sieht deshalb mindestens ein Federelement vor, um den Aktorkörper in der Aufnahmehülse zu zentrieren und/oder Bauteiltoleranzen des Aktorkörpers oder der Aufnahmehülse auszugleichen. Das erfindungsgemäß vorgesehene Federelement kann also zwei unterschiedliche Funktionen erfüllen, nämlich zum einen die Zentrierung des Aktorkörpers innerhalb der Aufnahmehülse und zum anderen den Ausgleich von Bauteiltoleranzen. Es ist jedoch im Rahmen der Erfindung nicht erforderlich, dass die erfindungsgemäße Aufnahmehülse beide Funktionen erfüllt. Es ist vielmehr auch möglich, dass die erfindungsgemäße Aufnahmehülse nur einen Ausgleich von Bauteiltoleranzen des Aktorkörpers bewirkt, ohne den Aktorkörper innerhalb der Aufnahmehülse zu zentrieren. Darüber hinaus besteht auch die Möglichkeit, dass das erfindungsgemäß vorgesehene Federelement lediglich eine Zentrierung des Aktorkörpers innerhalb der Aufnahmehülse bewirkt, ohne Bauteiltoleranzen von Aktorkörper oder Aufnahmehülse auszugleichen.

In einem bevorzugten Ausführungsbeispiel der Erfindung liegt jeweils auf gegenüberliegenden Seiten des Aktorkörpers jeweils mindestens ein Federelement, wobei die einander gegenüberliegenden Federelemente jeweils von außen auf den Aktorkörper drücken, um den Aktorkörper in der Aufnahmehülse zu zentrieren. Die von den einzelnen Federelementen auf den Aktor ausgeübten Federkräfte sind hierbei vorzugsweise bezüglich der Aktorlängsachse radial ausgerichtet. Die einander gegenüberliegend angeordneten Federelemente der erfindungsgemäßen Aufnahmehülse zentrieren den Aktorkörper innerhalb der Aufnahmehülse jedoch nur in einem Bewegungsfreiheitsgrad. Zur vollständigen Fixierung des Aktorkörpers in allen quergerichteten Bewegungsfreiheitsgraden sind deshalb vorzugsweise zwei weitere Federelemente vorgesehen, die auf gegenüberliegenden Seiten des Aktorkörpers angeordnet sind und jeweils von außen auf den Aktorkörper drücken, um den Aktorkörper in der Aufnahmehülse auch in einem zweiten Bewegungsfreiheitsgrad zu zentrieren. Zur Erreichung einer vollständigen Querzentrierung des Aktorkörpers innerhalb der Aufnahmehülse sind die Kraftachsen der beiden Federelementepaare zueinander angewinkelt und schließen vorzugsweise einen im Wesentlichen rechten Winkel ein.

In einem anderen Ausführungsbeispiel der Erfindung ist dagegen jeweils auf einer Seite des Aktorkörpers ein Federelement angeordnet, das von außen auf den Aktorkörper drückt, während sich auf der gegenüberliegenden Seite des Aktorkörpers ein starrer Anschlag befindet. Das Federelement drückt den Aktorkörper hierbei also gegen den starren Anschlag, so dass der Aktorkörper eine definierte Position einnimmt. Auch hierbei ist vorzugsweise vorgesehen, dass der Aktorkörper in allen möglichen Querbewegungsrichtungen exakt positioniert wird. Hierzu ist vorzugsweise ein weiteres Federelement vorgesehen, das von einer anderen Seite von außen auf den Aktorkörper drückt und diesen gegen einen auf der gegenüberliegenden Seite angeordneten weiteren Anschlag drückt. Die beiden Federelemente bewirken hierbei also mit den beiden starren Anschlägen eine exakte Positionierung des Aktorkörpers innerhalb der Aufnahmehülse in allen Querrichtungen. Vorzugsweise sind die Kraftachsen der beiden Federelemente hierbei wieder zueinander angewinkelt und schließen vorzugsweise einen rechten Winkel ein, um eine möglichst exakte Positionierung des Aktorkörpers zu erreichen. Bei diesem Ausführungsbeispiel der Erfindung werden Bauteiltoleranzen des Aktorköpers und der Aufnahmehülse ausgeglichen, jedoch erfolgt nicht notwendigerweise eine Zentrierung des Aktorkörpers innerhalb der Aufnahmehülse, da die Position des Aktorkörpers durch die toleranzbehafteten starren Anschläge vorgegeben ist.

Die erfindungsgemäße Aufnahmehülse weist zwei Führungsbohrungen zur Halterung des Aktorkörpers auf, wobei an den beiden Führungsbohrungen jeweils mindestens ein Federelement angeordnet ist, um den Aktorkörper in den Führungsbohrungen zu zentrieren und/oder Bauteiltoleranzen auszugleichen. Die beiden Führungsbohrungen sind hierbei vorzugsweise im Wesentlichen rechteckig, um die üblichen Piezostapel mit einem rechteckigen Querschnitt aufnehmen zu können, wobei an jeder Seitenkante der Führungsbohrungen jeweils ein Federelement angeordent ist, so dass an jeder Führungsbohrung insgesamt mindestens vier Federelemente auf den Aktorkörper wirken und diesen innerhalb der Führungsbohrungen zentrieren.

Es ist jedoch alternativ auch möglich, dass jede Führungsbohrung an zwei ihrer Seitenkanten jeweils ein Federelement und an ihren beiden anderen Seitenkanten jeweils einen Anschlag aufweist, wobei die Federelemente jeweils einem Anschlag gegenüberliegen. Bei dieser Ausführungsform drücken die beiden Federelemente den Aktorkörper gegen die jeweils zugehörigen starren Anschläge, so dass die Endposition des Aktorkörpers durch die starren Anschläge vorgegeben ist.

Bei der vorstehend beschriebenen Variante mit starren Anschlägen sind die beiden Federelemente an den beiden Führungsbohrungen vorzugsweise jeweils an benachbarten Seitenkanten angeordnet, während die beiden Anschläge an den beiden Führungsbohrungen jeweils an den anderen beiden benachbarten Seitenkanten angeordnet sind. Die beiden Federelemente haben hierbei also Kraftwirkungsachsen, die rechtwinklig zueinander ausgerichtet sind, was zu einer exakten Positionierung des Aktorkörpers innerhalb der Aufnahmehülse führt.

Die einzelnen Federelemente sind vorzugsweise einstückig an die Aufnahmehülse angeformt, die beispielsweise aus Kunststoff bestehen kann.

In einer auch als einarmig bezeichneten Ausführungsform der Federelemente sind diese langgestreckt, wobei eines ihrer Enden einstückig an die Aufnahmehülse angeformt ist, während das andere Ende frei ist und elastisch auf den Aktorkörper drückt.

Es ist jedoch alternativ auch möglich, dass die Federelemente langgestreckt sind und an ihren beiden Enden einstückig an die Aufnahmehülse angeformt sind, wobei der mittlere Bereich der Federelemente elastisch gegen den Aktorkörper drückt.

Ferner ist zu erwähnen, dass der Berührungskontakt zwischen den einzelnen Federelementen und dem Aktorkörper vorzugsweise punktförmig oder linienförmig ist, um bei der im Betrieb auftretenden Längsdehnung bzw. -kürzung des Aktorkörpers die Reibung zwischen dem Aktorkörper und den Federelementen zu verringern. Ein derartiger punkt- oder linienförmiger Berührungskontakt zwischen den Federelementen und dem Aktorkörper kann beispielsweise dadurch erreicht werden, dass an den Federelementen Vorsprünge angeordnet sind, die den punkt- oder lininenförmigen Berührungskontakt mit dem Aktorkörper bilden.

Weiterhin können die Federelemente eine Einführschräge aufweisen, um die Einführung des Aktorkörpers in die Aufnahmehülse zu erleichtern.

Die Erfindung umfasst jedoch nicht nur die vorstehend beschriebene erfindungsgemäß gestaltete Aufnahmehülse, sondern auch einen kompletten Piezoaktor mit einer erfindungsgemäßen Aufnahmehülse und einem in diese eingesetzten Aktorkörper.

Ferner umfasst die Erfindung auch einen Injektor für eine Einspritzanlage einer Brennkraftmaschine mit einem derartigen Piezoaktor sowie eine komplette Einspritzanlage, die einen solchen Injektor aufweist.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Fig. 1a und 1b: ein erstes Ausführungsbeispiel einer erfindungsgemäßen Aufnahmehülse für einen Piezoaktor,
- Fig. 2a und 2b: ein alternatives Ausführungsbeispiel einer erfindungsgemäßen Aufnahmehülse,
- Fig. 3a und 3b: ein weiteres alternatives Ausführungsbeispiel für eine erfindungsgemäße Aufnahmehülse,
- Fig. 4a und 4b: ein viertes Ausführungsbeispiel für eine derartige Aufnahmehülse.

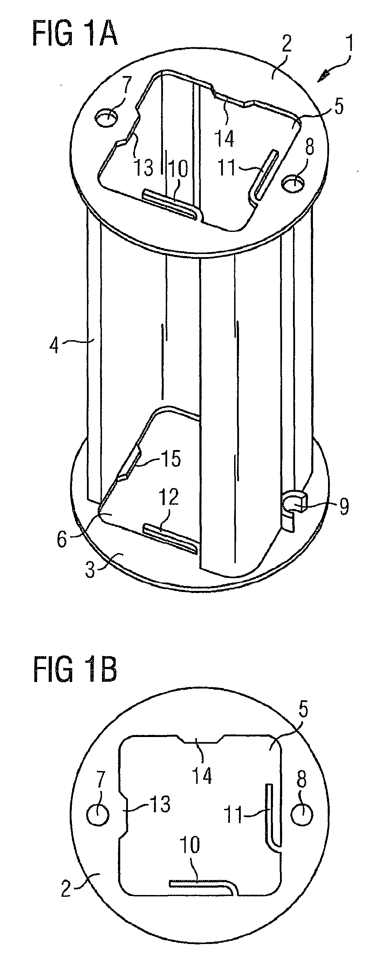

Die Figuren 1a und 1b zeigen eine aus Kunststoff bestehende Aufnahmehülse 1, die bei der Herstellung eines Piezoaktors für einen Injektor einer Einspritzanlage für eine Brennkraftmaschine eingesetzt wird.

Die Aufnahmehülse 1 hat hierbei zum einen die Aufgabe, einen in die Aufnahmehülse 1 eingesetzten Piezostapel und zwei zugehörige elektrische Anschlussstifte bei der elektrischen Kontaktierung zu fixieren, wobei die Kontaktierung des Piezostapels durch eine Drahtbewicklung erfolgt.

Zum anderen hat die Aufnahmehülse 1 bei der Herstellung eines Piezoaktors die Aufgabe, den Piezostapel und die zugehörigen elektrischen Anschlussstifte beim Vergießen mit Silikon zu fixieren, bis die Vergussmasse ausgehärtet ist und den Piezostapel sowie die zugehörigen elektrischen Anschlussstifte dann unverrückbar fixiert sind.

Zur Erfüllung dieser beiden Aufgaben ist die Aufnahmehülse käfigartig geformt und weist zwei Stirnplatten 2, 3 auf, die durch axial verlaufende Stege 4 miteinander verbunden sind, wobei in den beiden Stirnplatten 2, 3 jeweils eine im wesentlichen quadratische Führungsbohrung 5, 6 angeordnet ist. Bei der Herstellung eines Piezoaktors wird ein Piezostapel mit einem ebenfalls im Wesentlichen quadratischen Querschnitt in die Führungsbohrungen 5, 6 der beiden Stirnplatten 2, 3 eingeführt, wobei der Piezostapel axial etwas nach außen über die Stirnplatten 2, 3 hinausragt, so dass der Piezostapel in den Führungsbohrungen 5, 6 seitlich geführt wird.

In der oberen Stirnplatte 2 sind zwei weitere Führungsbohrungen 7, 8 angeordnet, die im montierten Zustand zwei elektrische Anschlussstifte führen, wobei das untere Ende der elektrischen Anschlussstifte durch ein Klemmlager 9 geführt wird.

An den inneren Seitenkanten der beiden Führungsbohrungen 5, 6 sind hierbei jeweils zwei Federelemente 10, 11 bzw. 12 angeordnet, wobei den Federelementen 10, 11, 12 jeweils ein starrer Anschlag 13, 14, 15 gegenüberliegt, der an einer Seitenkante der Führungsbohrung 5 bzw. 6 im Wesentlichen mittig und einstückig angeformt ist.
Die Federelemente 10, 11, 12 bestehen aus Kunststoff und sind langgestreckt, wobei eines ihrer Enden einstückig an eine Seitenkante der Führungsbohrung 5 bzw. 6 angeformt ist, so dass die Federelemente 10, 11, 12 mit ihrem freien Ende elastisch schwingen können.

Im montierten Zustand drücken die Federelemente 10-12 einen in die Führungsbohrungen 5, 6 eingesetzten Piezostapel in Richtung auf die jeweils gegenüberliegenden starren Anschläge 13-15, so dass der Piezostapel in der Aufnahmehülse 1 unabhängig von Bauteiltoleranzen des Piezostapels eine definierte Position einnimmt.

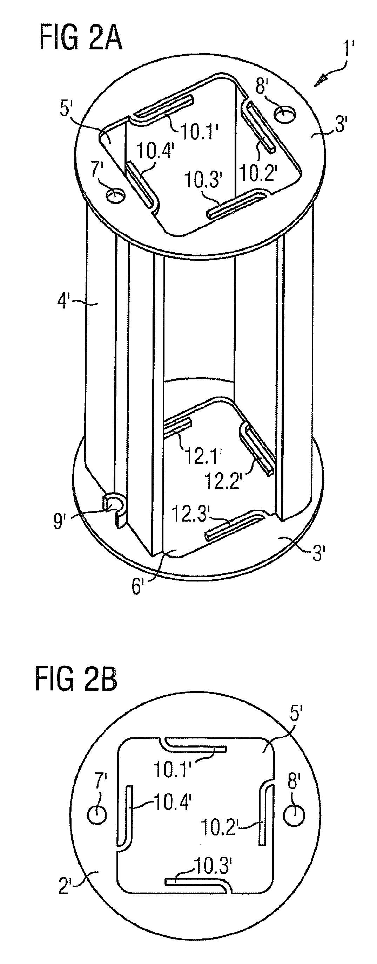

Das in den Figuren 2a und 2b dargestellte Ausführungsbeispiel einer Aufnahmehülse 1' stimmt weitgehend mit dem vorstehend beschriebenen und in den Figuren 1a und 1b dargestellten Ausführungsbeispiel überein, so dass zur Vermeidung von Wiederholungen auf die vorstehende Beschreibung verwiesen wird und im Folgenden für entsprechende Bauteile dieselben Bezugszeichen verwendet werden, die lediglich zur Unterscheidung mit einem Apostroph versehen sind.

Eine Besonderheit dieses Ausführungsbeispiels besteht darin, dass an jeder Seitenkante der beiden Führungsbohrungen 5', 6' jeweils ein Federelement 10.1'-10.4', 12.1'-12.3' angeformt ist. Im montierten Zustand ist der Piezostapel im Bereich der beiden Stirnplatten 2', 3' der Aufnahmehülse 1' also jeweils von zwei rechtwinklig zueinander angeordneten Paaren von Federelementen 10.1', 10.3' bzw. 10.2', 10.4' umgeben, die von außen auf den Piezostapel drücken und diesen dadurch innerhalb der Aufnahmehülse 1' zentrieren.

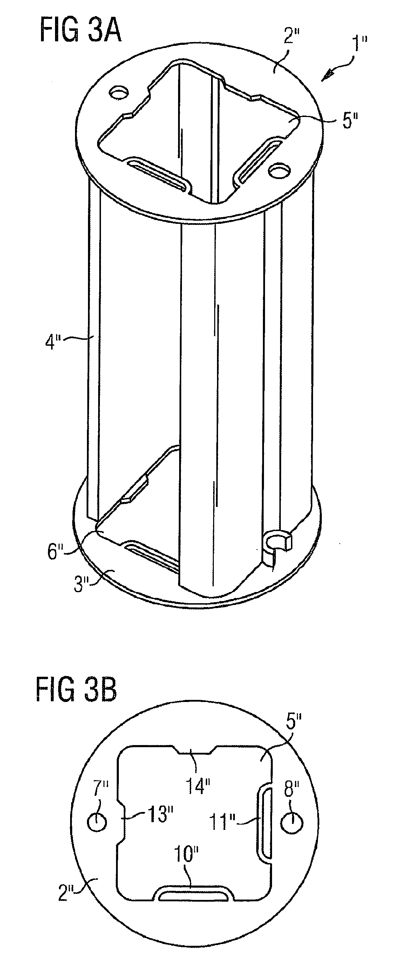

Das in den Figuren 3a und 3b dargestellte Ausführungsbeispiel einer erfindungsgemäßen Aufnahmehülse 1'' stimmt weitgehend mit dem vorstehend beschriebenen und in den Figuren 1a und 1b dargestellten Ausführungsbeispiel überein, so dass zur Vermeidung von Wiederholungen weitgehend auf die vorstehende Beschreibung verwiesen wird um im Folgenden für entsprechende Bauteile dieselben Bezugszeichen verwendet werden, die lediglich zur Unterscheidung durch zwei Apostrophe gekennzeichnet sind.

Eine Besonderheit dieses Ausführungsbeispiels besteht in der Ausgestaltung der Federelemente 10'', 11'', die langgestreckt sind und an ihren beiden Enden jeweils einstückig an den Rand der Führungsbohrung 5" bzw. 6" angeformt sind, so dass der mittlere Bereich der beiden Federelemente 10", 11'' federnd gegen den Piezostapel drückt.

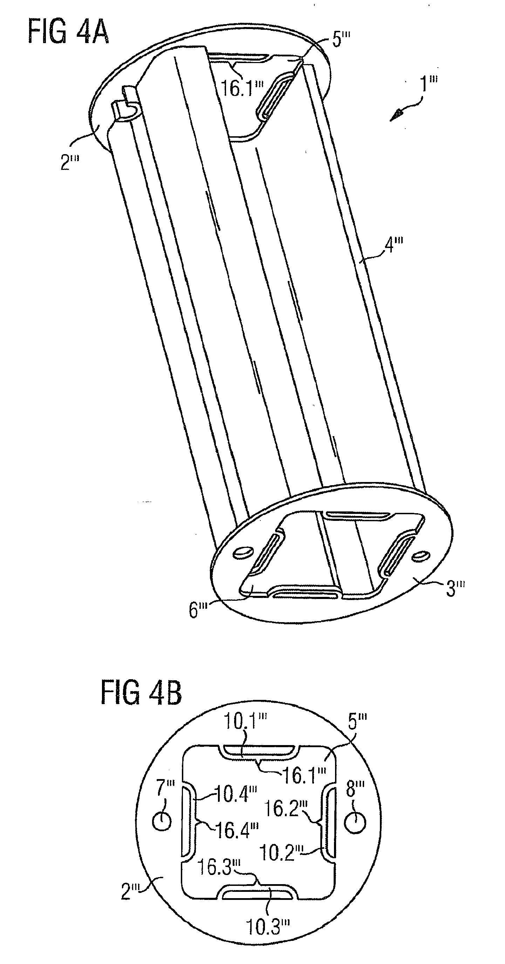

Schließlich stimmt auch das in den Figuren 4a und 4b dargestellte alternative Ausführungsbeispiel einer Aufnahmehülse 1''' weitgehend mit dem vorstehend beschriebenen und in den Figuren 2a und 2b dargestellten Ausführungsbeispiel überein, so dass zur Vermeidung von Wiederholungen weitgehend auf die vorstehende Beschreibung verwiesen wird und im Folgenden für entsprechende Bauteile dieselben Bezugszeichen verwendet werden, die lediglich zur Unterscheidung durch drei Apostrophe gekennzeichnet sind.

Eine Besonderheit der Aufnahmehülse 1''' besteht in der Ausgestaltung der Federelemente 10.1'''-10.4''', die langgestreckt ausgebildet sind und an ihren beiden Enden jeweils einstückig an eine Seitenkante der Führungsbohrung 5''', 6''' angeformt sind, so dass jeweils der mittlere Bereich der einzelnen Federelemente 10.1'''-10.4''' elastisch federnd von außen auf den Piezostapel drückt.

Eine weitere Besonderheit besteht darin, dass an die einzelnen Federelemente 10.1''' jeweils mittig Vorsprünge 16.1'''-16.4''' angeformt sind, die im montierten Zustand in einem punktförmigen Berührungskontakt mit dem Piezostapel stehen. Auf diese Weise wird bei der im Betrieb auftretenden Längsdehnung bzw. -kürzung des Piezostapels die Reibung zwischen dem Piezostapel und den Federelementen 10.1'''-10.4''' herabgesetzt.

Schließlich besteht eine Besonderheit der Aufnahmehülse 1''' darin, dass die Federelemente 10.1'''-10.4''' eine Einführschräge aufweisen, wodurch das Einführen des Piezostapels in die Führungsbohrungen 5''' und 6"' erleichtert wird.

## Patentansprüche

1. Aufnahmehülse (1, 1' , 1'', 1''') zur Aufnahme eines Aktorkörpers, insbesondere eines Piezostapels eines Piezoaktors, der zum Antrieb eines Injektors einer Einspritzanlage für eine Brennkraftmaschine vorgesehen ist,
mit mindestens einem Federelement (10, 10.1'-10.4', 10.1'''-10.4''', 11) zur Zentrierung des Aktorkörpers in der Aufnahmehülse (1, 1', 1'', 1''') und/oder zum Ausgleich von Bauteiltoleranzen des Aktorkörpers,
**gekennzeichnet durch**
zwei Führungsbohrungen (5, 5', 5", 5''', 6, 6' , 6", 6''') zur Halterung des Aktorkörpers, wobei an den beiden Führungsbohrungen (5, 5', 5", 5''', 6, 6' , 6", 6''') jeweils mindestens ein Federelement (10, 10.1'-10.4', 10.1'''-10.''', 11) angeordnet ist, um den Aktorkörper in den Führungsbohrungen (5, 5' , 5'', 5''', 6, 6' , 6", 6''') zu zentrieren und/oder Bauteiltoleranzen des Aktorkörpers auszugleichen.

2. Aufnahmehülse (1, 1''') nach Anspruch 1,
**dadurch gekennzeichnet,**
**dass** auf gegenüberliegenden Seiten des Aktorkörpers jeweils mindestens ein Federelement (10.1',-10.4', 10.1'''-10.4"') angeordnet ist, wobei die Federelemente (10.1¹-10.4¹, 10.1'''-10.4''') jeweils von außen auf den Aktorkörper drücken, um den Aktorkörper in der Aufnahmehülse (1', 1''') zu zentrieren.

3. Aufnahmehülse (1, 1'') nach Anspruch 1 oder 2,
**dadurch gekennzeichnet,**
**dass** das Federelement (10, 10", 11, 11'') auf einer Seite des Aktorkörpers angeordnet ist und einseitig auf den Aktorkörper drückt, während auf der anderen Seite des Aktorkörpers ein Anschlag (13, 13'', 14, 14'') angeordnet ist.

4. Aufnahmehülse (1', 1''') nach Anspruch 1,
**dadurch gekennzeichnet,**
**dass** die beiden Führungsbohrungen (5', 6', 5''', 6''') jeweils im wesentlichen rechteckig sind und an jeder Seitenkante der beiden Führungsbohrungen (5', 6', 5''', 6''') jeweils ein Federelement (10.1'-10.4', 10.1'''-10.4''') angeordnet ist.

5. Aufnahmehülse (1, 1'') nach Anspruch 1,
**dadurch gekennzeichnet,**
**dass** die beiden Führungsbohrungen (5, 6, 5", 6") jeweils im wesentlichen rechteckig sind, wobei jede Führungsbohrung (5, 6, 5", 6") an zwei ihrer Seitenkanten jeweils ein Federelement (10, 11, 10'', 11'') und an ihren beiden anderen Seitenkanten jeweils einen Anschlag (13, 14, 13'', 14'') aufweist.

6. Aufnahmehülse (1, 1'') nach Anspruch 5,
**dadurch gekennzeichnet,**
**dass** die beiden Federelemente (10, 11, 10", 11'') an den beiden Führungsbohrungen (5, 6, 5", 6") jeweils an benachbarten Seitenkanten angeordnet sind und
**dass** die beiden Anschläge (13, 14, 13", 14") an den beiden Führungsbohrungen (5, 6, 5", 6") jeweils an benachbarten Seitenkanten angeordnet sind.

7. Aufnahmehülse (1, 1', 1'', 1''') nach einem der vorhergehenden Ansprüche,
**dadurch gekennzeichnet,**
**dass** die Federelemente (10, 10.1'-10.4', 10.1'''-10.4''', 11) einstückig an die Aufnahmehülse (1, 1', 1'', 1''') angeformt sind.

8. Aufnahmehülse (1, 1') nach Anspruch 7,
**dadurch gekennzeichnet,**
**dass** die Federelemente (10, 11, 10.1'-10.4') langgestreckt sind, wobei eines ihrer Enden einstückig an die Aufnahmehülse (1, 1') angeformt ist, während das andere Ende frei ist und elastisch auf den Aktorkörper drückt.

9. Aufnahmehülse (1'', 1''') nach Anspruch 7,
**dadurch gekennzeichnet,**
**dass** die Federelemente (10'', 11'', 10.1'''-10.4''') langgestreckt sind und an ihren beiden Enden einstückig an die Aufnahmehülse (1'', 1''') angeformt sind, wobei der mittlere Bereich der Federelemente (10", 11'', 10.1'''-10.4''') elastisch gegen den Aktorkörper drückt.

10. Aufnahmehülse (1''') nach einem der Ansprüche 1 bis 9,
**dadurch gekennzeichnet,**
**dass** das Federelement (10.1'''-10.4''') eine Einführschräge aufweist, um die Einführung des Aktorkörpers zu erleichtern.

11. Aufnahmehülse (1''') nach einem der vorhergehenden Ansprüche,
**gekennzeichnet durch**
einen im wesentlichen punktförmigen oder linienförmigen Berührungskontakt zwischen dem Federelement (10.1'''-10.4''') und dem Aktorkörper.

12. Aufnahmehülse (1''') nach Anspruch 11,
**dadurch gekennzeichnet,**
**dass** der linienförmige Berührungskontakt parallel zur Längsachse des Aktorkörpers ausgerichtet ist.

13. Aufnahmehülse (1''') nach Anspruch 11 oder 12,
**dadurch gekennzeichnet,**
**dass** an das Federelement (10.1'''-10.4''') ein Vorsprung (16.1'''-16.4''') angeformt ist, der den punktförmigen oder linienförmigen Berührungskontakt mit dem Aktorkörper bildet.

14. Aufnahmehülse (1, 1', 1'', 1''') nach einem der vorhergehenden Ansprüche,
**dadurch gekennzeichnet,**
**dass** das Federelement (10, 10.1'-10.4', 10.1'''-10.4''', 11) bis auf den Berührungskontakt mit dem Aktorkörper vollständig mit einer Vergussmasse umhüllbar ist.

15. Aufnahmehülse (1, 1', 1'', 1''') nach einem der vorhergehenden Ansprüche,
**dadurch gekennzeichnet,**
**dass** sich zwischen den Federelementen (10, 10.1'-10.4', 10.1'''-10.4''', 11) und der Aufnahmehülse (1, 1' , 1'', 1''') ein Spalt befindet, der ausreichend groß ist, um beim Vergießen der Aufnahmehülse (1, 1', 1'', 1''') das Eindringen einer Vergussmasse zu ermöglichen.

16. Piezoaktor mit einer Aufnahmehülse (1, 1', 1'', 1''') nach einem der vorhergehenden Ansprüche und einem in der Aufnahmehülse (1, 1', 1'', 1''') angeordneten Aktorkörper.

17. Injektor für eine Einspritzanlage einer Brennkraftmaschine mit einem Piezoaktor gemäß Anspruch 16.

18. Einspritzanlage für eine Brennkraftmaschine mit einem Injektor gemäß Anspruch 17.

## Claims

1. Receiving sleeve (1, 1', 1'', 1''') for an actuator body, in particular for accommodating a piezo stack of a piezo actuator which is provided for driving an injector of an injection system for an internal combustion engine,
having at least one spring element (10, 10.1'-10.4', 10.1'''-10.4''', 11) for centring the actuator body in the receiving sleeve (1, 1', 1'', 1''') and/or for compensating for component tolerances of the actuator body,
**characterised by**
two guide holes (5, 5', 5", 5''', 6, 6', 6", 6''') for supporting the actuator body, with at least one spring element (10, 10.1'-10.4', 10.1'''-10.4''', 11) being disposed on each of the two guide holes (5, 5', 5", 5"', 6, 6', 6", 6''') in order to centre the actuator body in the guide holes (5, 5', 5", 5''', 6, 6', 6", 6''') and/or to compensate for component tolerances of the actuator body.

2. Receiving sleeve (1, 1''') according to claim 1,
**characterised in that**
one or more spring elements (10.1'-10.4', 10.1'''-10.4''') are disposed in each case on opposite sides of the actuator body, with the spring elements (10.1'-10.4', 10.1'''-10.4''') pressing against the actuator body from outside in each case in order to centre the actuator body in the receiving sleeve (1', 1''').

3. Receiving sleeve (1, 1 ") according to claim 1 or 2,
**characterised in that** t
the spring element (10, 10", 11, 11 ") is disposed on one side of the actuator body and presses unilaterally against the actuator body, while a stop (13, 13", 14, 14") is disposed on the other side of the actuator body.

4. Receiving sleeve (1', 1''') according to claim 1,
**characterised in that** t
the two guide holes (5', 6', 5''', 6''') are in each case substantially square and a spring element (10.1'-10.4', 10.1'''-10.4''') is disposed in each case on each lateral edge of the two guide holes (5', 6', 5''', 6''').

5. Receiving sleeve (1, 1") according to claim 1,
**characterised in that** t
the two guide holes (5, 6, 5", 6") are in each case substantially square, with each guide hole (5, 6, 5", 6") having a spring element (10, 11, 10'', 11'') in each case on two of its lateral edges and a stop (13, 14, 13", 14") in each case on its other two lateral edges.

6. Receiving sleeve (1, 1") according to claim 5,
**characterised in that t**
the two spring elements (10, 11, 10", 11 ") are disposed on the two guide holes (5, 6, 5", 6") on adjacent lateral edges in each case and
the two stops (13, 14, 13", 14") are disposed on the two guide holes (5, 6, 5", 6") on adjacent lateral edges in each case.

7. Receiving sleeve (1, 1', 1'', 1''') according to one of the preceding claims,
**characterised in that** t
the spring elements (10, 10.1'-10.4', 10.1 '''-10.4''', 11) are formed of a piece with the receiving sleeve (1, 1', 1'', 1''').

8. Receiving sleeve (1, 1') according to claim 7,
**characterised in that** t
the spring elements (10, 11, 10.1'-10.4') are elongated, with one of their ends being formed of a piece with the receiving sleeve (1, 1'), while the other end is free and presses elastically against the actuator body.

9. Receiving sleeve (1'', 1''') according to claim 7, **characterised in that**
the spring elements (10", 11 ", 10.1'''-10.4''') are elongated and formed of a piece with the receiving sleeve (1 ", 1''') at both of their ends, with the central section of the spring elements (10", 11 ", 10.1 '''-10.4''') pressing elastically against the actuator body.

10. Receiving sleeve (1''') according to one of claims 1 to 9,
**characterised in that**
the spring element (10.1 '''-10.4''') is bevelled in order to facilitate insertion of the actuator body.

11. Receiving sleeve (1''') according to one of the preceding claims,
**charaterised by**
a substantially punctiform or linear contact between the spring element (10.1 '''-10.4''' and the actuator body.

12. Receiving sleeve (1''') according to claim 11,
**characterised in that**
the linear contact is orientated parallel to the longitudinal axis of the actuator body.

13. Receiving sleeve (1''') according to claim 11 or 12,
**characterised in that**
a projecting lug (16.1'''-16. 4''') is formed of a piece on the spring element (10.1'''-10.4''') and constitutes the punctiform or linear contact with the actuator body.

14. Receiving sleeve (1, 1', 1'', 1''') according to one of the preceding claims,
**characterised in that**
with the exception of the contact with the actuator body the spring element (10, 10.1'-10.4', 10.1'''-10.4''', 11) can be completely coated with a potting compound.

15. Receiving sleeve (1, 1', 1'', 1''') according to one of the preceding claims,
**characterised in that**
between the spring elements (10, 10.1'-10.4, 10.1 '''-10.4''', 11) and the receiving sleeve (1, 1', 1'', 1''') there is a gap which is sufficiently large to allow a potting compound to penetrate during the encapsulation of the receiving sleeve (1, 1', 1'', 1''').

16. Piezo actuator having a receiving sleeve (1, 1', 1 ", 1''') according to one of the preceding claims and an actuator body disposed in the receiving sleeve (1, 1', 1'', 1''').

17. Injector for an injection system of an internal combustion engine having a piezo actuator according to claim 16.

18. Injection system for an internal combustion engine having an injector according to claim 17.

## Revendications

1. Manchon de logement (1, 1', 1", 1"") destiné à recevoir un corps d'actionneur, en particulier une pile piézoélectrique d'un actionneur piézoélectrique, qui est prévu pour entraîner un injecteur d'une installation d'injection pour un moteur à combustion interne,
avec au moins un élément de ressort (10, 10.1'-10.4', 10.1'''-10.4''', 11) destiné à centrer le corps de l'actionneur dans le manchon de logement (1, 1', 1", 1"') et/ou à compenser des tolérances de composant du corps de l'actionneur,
**caractérisé par**
deux alésages de guidage (5, 5', 5", 5"', 6, 6', 6", 6"') destinés à maintenir le corps de l'actionneur, dans lequel au moins un élément de ressort (10, 10.1'-10.4', 10.1"'-10.4"', 11) est respectivement agencé au niveau des deux alésages de guidage (5, 5', 5", 5"', 6, 6', 6", 6"') afin de centrer le corps de l'actionneur dans les alésages de guidage (5, 5', 5", 5"', 6, 6', 6", 6"') et/ou de compenser des tolérances de composant du corps de l'actionneur.

2. Manchon de logement (1, 1"') selon la revendication 1,
**caractérisé en ce qu'**au moins un élément de ressort (10.1'-10.4', 10.1"'-10.4"') est respectivement agencé sur les côtés opposés du corps de l'actionneur, dans lequel les éléments de ressort (10.1'-10.4', 10.1"'-10.4"') exercent respectivement une pression sur le corps de l'actionneur depuis l'extérieur afin de centrer le corps de l'actionneur dans le manchon de logement (1', 1''').

3. Manchon de logement (1, 1 ") selon la revendication 1 ou 2,
**caractérisé en ce que** l'élément de ressort (10, 10", 11, 11 ") est agencé sur un côté du corps de l'actionneur et exerce une pression unilatéralement sur le corps de l'actionneur, tandis qu'une butée (13, 13", 14, 14") est agencée sur l'autre côté du corps de l'actionneur.

4. Manchon de logement (1', 1"') selon la revendication 1,
**caractérisé en ce que** les deux alésages de guidage (5', 6', 5"', 6"') sont respectivement sensiblement rectangulaires, et **en ce qu'**un élément de ressort (10.1'-10.4', 10.1'''-10.4''') est respectivement agencé sur chaque bord latéral des deux alésages de guidage (5', 6', 5"', 6"').

5. Manchon de logement (1, 1 ") selon la revendication 1,
**caractérisé en ce que** les deux alésages de guidage (5, 6, 5", 6") sont respectivement sensiblement rectangulaires, dans lequel chaque alésage de guidage (5, 6, 5", 6") présente respectivement sur deux de ses bords latéraux un élément de ressort (10, 11, 10", 11 ") et respectivement sur ses deux autres bords latéraux une butée (13, 14, 13", 14").

6. Manchon de logement (1, 1 ") selon la revendication 5,
**caractérisé en ce que** les deux éléments de ressort (10, 11, 10", 11 ") sont agencés sur les deux alésages de guidage (5, 6, 5", 6"), respectivement sur des bords latéraux avoisinants, et **en ce que** les deux butées (13, 14, 13", 14") sont agencées sur les deux alésages de guidage (5, 6, 5", 6"), respectivement sur des bords latéraux avoisinants.

7. Manchon de logement (1, 1', 1", 1"') selon l'une des revendications précédentes,
**caractérisé en ce que** les éléments de ressort (10, 10.1'-10.4', 10.1'''-10.4''', 11) sont formés d'une seule pièce sur le manchon de logement (1, 1', 1", 1"').

8. Manchon de logement (1, 1') selon la revendication 7,
**caractérisé en ce que** les éléments de ressort (10, 11, 10.1'-10.4') ont une forme allongée, dans lequel une de leurs extrémités est formée d'une seule pièce sur le manchon de logement (1, 1') tandis que l'autre extrémité est libre et exerce une pression de façon élastique sur le corps de l'actionneur.

9. Manchon de logement (1 ", 1"') selon la revendication 7,
**caractérisé en ce que** les éléments de ressort (10", 11 ", 10.1 '''-10.4''') ont une forme allongée et sont formés d'une seule pièce sur le manchon de logement (1 ", 1"') à leurs deux extrémités, dans lequel la zone centrale des éléments de ressort (10", 11", 10.1'''-10.4''') exerce une pression de façon élastique contre le corps de l'actionneur.

10. Manchon de logement (1''')selon l'une des revendications 1 à 9,
**caractérisé en ce que** l'élément de ressort (10.1"'-10.4"') présente un biseau d'insertion afin de faciliter l'insertion du corps de l'actionneur.

11. Manchon de logement (1'") selon l'une des revendications précédentes,
**caractérisé par** une zone de contact essentiellement en forme de point ou en forme de ligne entre l'élément de ressort (10.1 '''-10.4''') et le corps de l'actionneur.

12. Manchon de logement (1"') selon la revendication 11,
**caractérisé en ce que** la zone de contact en forme de ligne est orientée parallèlement à l'axe longitudinal du corps de l'actionneur.

13. Manchon de logement (1"') selon la revendication 11 ou 12,
**caractérisé**
**en ce qu'**une saillie (16.1'''-16.4''') est formée sur l'élément de ressort (10.1'''-10.4'''), laquelle saillie constitue la zone de contact en forme de point ou en forme de ligne avec le corps de l'actionneur.

14. Manchon de logement (1, 1', 1", 1"') selon l'une des revendications précédentes,
**caractérisé en ce que** l'élément de ressort (10, 10.1'-10.4', 10.1'''-10.4''', 11) peut être entièrement enveloppé dans une masse de scellement jusqu'au niveau de la zone de contact avec le corps de l'actionneur.

15. Manchon de logement (1, 1', 1", 1"') selon l'une des revendications précédentes,
**caractérisé en ce qu'**une fente se situe entre les éléments de ressort (10, 10.1'-10.4', 10.1'''-10.4''', 11) et le manchon de logement (1, 1', 1", 1'''), laquelle fente est suffisamment grande pour permettre la pénétration d'une masse de scellement lors du coulage du manchon de logement (1, 1', 1", 1 "').

16. Actionneur piézoélectrique avec un manchon de logement (1, 1', 1", 1"') selon l'une des revendications précédentes et un corps d'actionneur agencé dans le manchon de logement (1, 1', 1", 1 "').

17. Injecteur pour une installation d'injection d'un moteur à combustion interne avec un actionneur piézoélectrique selon la revendication 16.

18. Installation d'injection pour un moteur à combustion interne avec un injecteur selon la revendication 17.
